# EUROPEAN PATENT APPLICATION

(11) **EP 0 529 757 A1**
(43) Date of publication of application: **03.03.1993**
(21) Application number: 92300615.9
(22) Date of filing: 24.01.1992
(51) Int. Cl.: G01R 11/04

(54) **Enclosure**

(30) Priority: 30.08.1991 US 752304
(71) Applicant: GENERAL ELECTRIC COMPANY, Schenectady, NY 12345 (US)
(72) Inventor: Miller, David John, South Berwick, Maine 03908 (US); Babineau, Paul J., Ashburnham, Massachusetts 01430 (US)
(74) Representative: Pratt, Richard Wilson

(57) **Abstract**

An enclosure, comprising means for housing a meter register, means for enabling an observer to view displays on a display of the meter register, and means for providing that said housing is environmentally sealed.

## Description

### I. Background of the Invention

### A. Field of the Invention

The present invention relates to energy meters, and more particularly, relates to an enclosure for a meter register.

### B. Related Art

An electronic register may be installed in either an indoor or outdoor environment. An enclosure for such a register, therefore, must be environmentally sealed. Further, it is preferable that the enclosure be tamper resistant yet provide easy access to certain register components, e.g., a battery which must be removed and replaced.

Known registers typically are disposed within the meter cover and no separate enclosure for the register is required. A need exists, however, to provide a separate register enclosure when the register is disposed outside the meter cover.

### II. Summary of the Invention

The present energy meter register enclosure utilizes ultrasonic welding and plastic snaps to provide a housing and protection for the electronic register components. The ultrasonic welding, in conjunction with gaskets on the front bezel and rear panel, provide an environmentally sealed enclosure to protect the electronic components from damage due to varying temperature changes, sunlight exposure and humidity. The enclosure also includes a window for viewing information on a liquid crystal display, a D-ring for interfacing with an optical programming device, and a battery hatch door for replacing a 1/2 AA or full AA battery. Push buttons are assessable under the battery hatch door for testing, displaying of information, and resetting the demand function.

The front bezel is snapped into the enclosure and held in place by snaps molded in the bezel. If the rear panel is properly removed, the snaps are assessable from the back of the register and can be deflected to remove the bezel assembly. On the rear panel there are loopholes that allow sealing the register mounting screws with wire seals to prevent unscrewing. There is also a loophole on the battery hatch door for a wire seal to prevent undesired opening of the hatch door.

### III. Brief Description of the Drawings

These and other objects of the present invention, together with further features and advantages thereof, will become apparent from the following detailed specification when read together with the accompanying drawings, in which:
Figure 1 is a perspective view of an enclosure in accordance with one embodiment of the present invention;
Figure 2A is a perspective view of the front bezel component;
Figure 2B is a perspective view of the back of the front bezel component;
Figure 3 is a front view of the front bezel component illustrated in Figure 2
Figure 4 is a perspective view of the inside of the door shown in Figure 1;
Figure 5 is a perspective view of the outside of the door shown in Figure 4;
Figure 6 is a perspective view of the top enclosure portion illustrated in Figure 1;
Figure 7 is a perspective view of the bottom enclosure portion illustrated in Figure 1;
Figure 8 is a perspective view of the rear panel shown in Figure 1;
Figure 9 is a perspective view of components of one embodiment of the present enclosure just prior to final assembly;
Figure 10 is a side view of the spring clip; and
Figure 11 is a side view of the battery spring.

### IV. Detailed Description of the Drawings

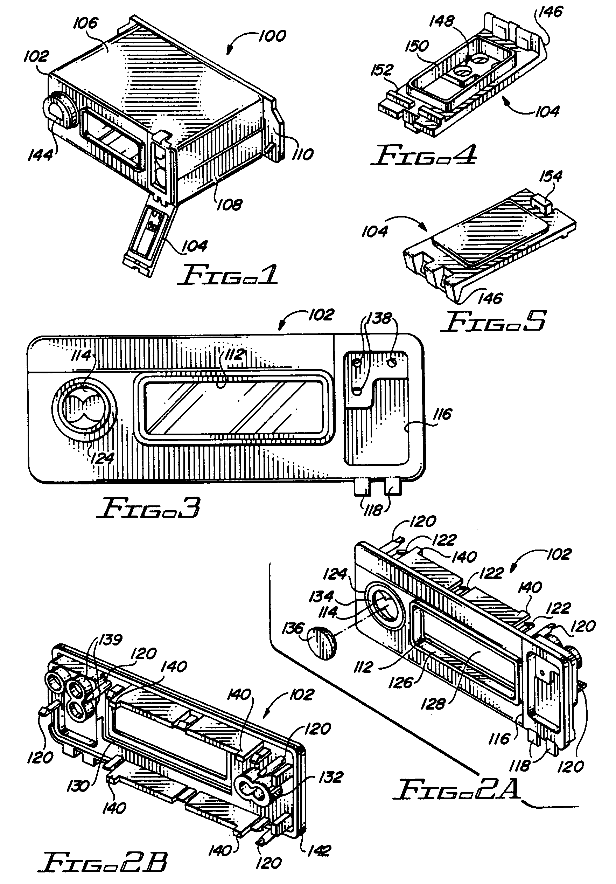

As shown in Figure 1, there are five basic components of the present enclosure 100 - a front bezel 102, a door 104, a top enclosure portion 106, a bottom enclosure portion 108, and a rear panel 110. These components preferably are injection molded from thermoplastic polycarbonate (GE Lexan* Resin #503-831 - * Lexan is a registered trademark of General Electric Company).

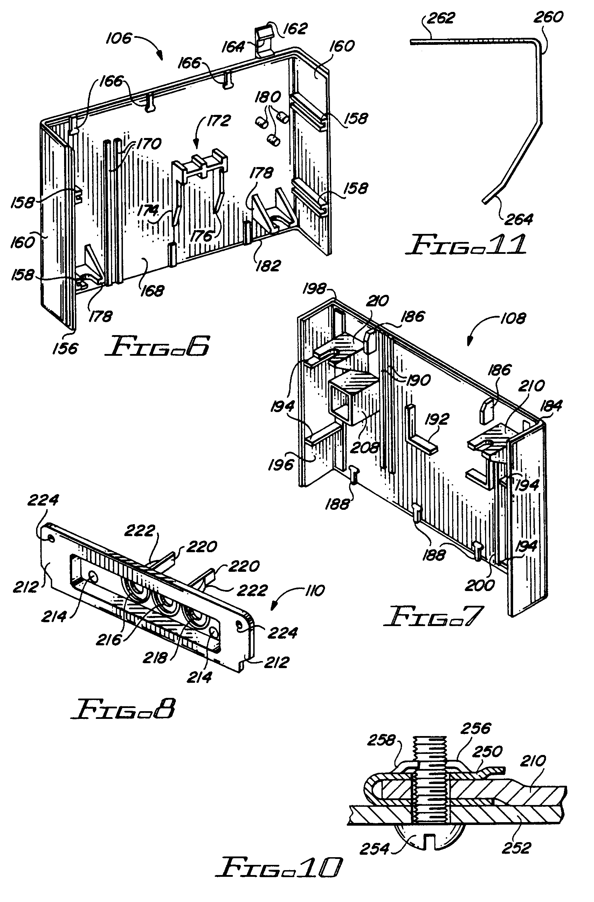

Referring to Figures 2A-B, the front bezel 102 is, for example, 4.875 inches wide by 1.800 inches high with varying wall thickness from 0.062 inches to 0.172 inches. The front bezel 102 includes an LCD window 112, an optics port 114, a battery hatch opening 116, door hinges 118, board mounting snaps 120, bezel mounting snaps 122, and a D-ring groove 124.

The LCD window 112 is 2.272 inches by 0.921 inches high in the viewing area. The window 112 has a flange 126 around the outside that protrudes by 0.06 inches out of the front of the bezel and has a 30 degree angle all around the window 112 to increase the viewing angle. An LCD of a register board (not shown) typically is located behind a 0.06 inch thick clear Lexan lens 128 causing the front of the LCD to be recessed 0.23 inches from the outermost part of the bezel 102. The 0.06 inch thick clear Lexan lens 128 is ultrasonically welded onto the back side of the bezel 102. The lens 128 is self fixtured into a rectangular recess 2.531 inches wide by 0.906 inches high by 0.063 inches deep from the back. A 0.016 high triangular shaped peak 130 (Fig. 2B), called an energy director, is molded into the recess around the perimeter. The lens 128 is ultrasonically welded inside this recess producing a hermetic seal between the bezel 102 and the lens 128.

The optics port 114 includes a shroud 132 (Fig. 2B) that surrounds two photodiodes soldered onto the electronic register board (not shown). A 0.06 inches recess 134 having a 0.38 inch diameter is molded on the front side to allow a clear optics lens 136 to be ultrasonically welded by means of a shear joint formed between the lens 136 and the recess 134 in the port 114. This shear joint produces a hermetic seal between the lens 136 and the bezel 102.

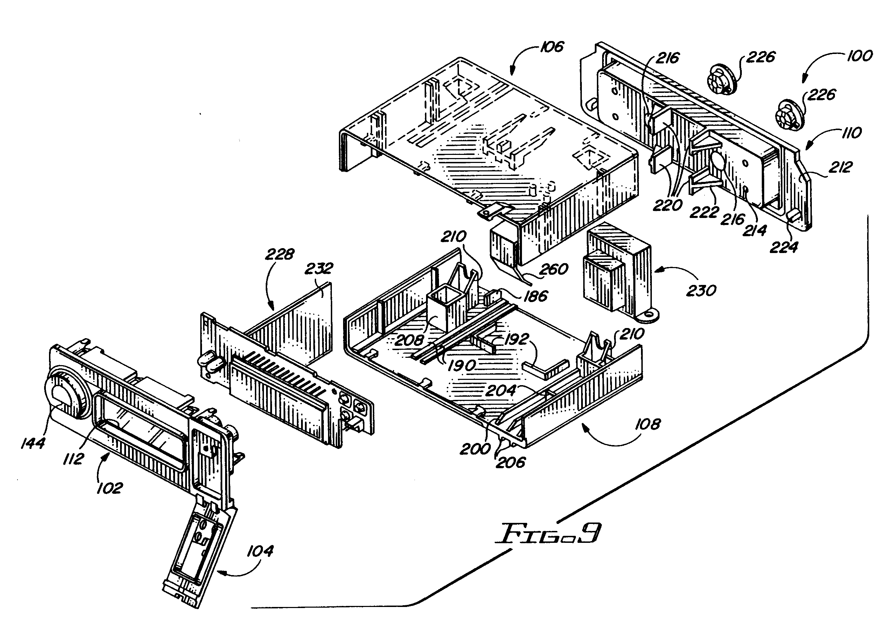

The battery hatch opening 116, as best shown in Figure 3, includes three openings 138 for receiving push button switches (not shown) used for test, display and resetting the register (not shown). The buttons preferably are small circular shaped plastic buttons with a circular flange on one end. These flanges seat in three recesses 139 (Fig. 2B) on the back side of the bezel 102 behind the three openings 138.

Below the battery hatch opening 116 are two hinges 118 molded into the bezel 102 that constrain the battery hatch door 104 and allow the door 104 to open and close. When the door 104 is assembled with the bezel 102 and snapped into the bottom enclosure portion 108, the assembly completes the bottom half of the hinge 118 for the door 104.

To assemble the register electronics board to the bezel 102, there are four snaps 120 (only three snaps 120 are shown in Figure 2A), molded into the back side of the bezel 102. Three of the snaps 120 are semi-circular shaped so that they can pass through holes in the electronics board (not shown) and snap inside the holes. The fourth snap is a conventional snap designed to support the right side of the board. To help align the board, during assembly, four tabs 140 (only two tabs 140 are visible in Figure 2A) protrude out the back and fit within cutouts in the board.

To assemble the bezel assembly to the top enclosure portion 106 and to the bottom enclosure portion 108, there are six snaps 122, three on top and three on bottom. The snaps 122 are designed to deflect over tabs (not shown in Figs. 2 - 3) as the bezel 102 is snapped in place. When the bezel 102 is snapped into place, a gasket 142 (Fig. 2B) on the back side of the bezel 102 is compressed, thus creating a water tight seal between the other portions of the enclosure 100 and the bezel 102. The snaps 140 hold the gasket 142 in compression. A D-ring 144 (Fig. 1) is ultrasonically welded into the groove 124 machined into the front face of the bezel 102 on the same centerline as the optics lens 136.

The door 104 provides easy replacement of a battery and access to the push-button switches without disassembling the enclosure 100. The door 104, as illustrated in Figure 4, is 2.114 inches high and 0.897 inches wide. The wall thickness varies from 0.068 inches to 0.281 inches and is cored out to minimize sink marks from generating in the mold process. The door 104 incorporates a second half 146 of the hinge to hold the door 104 onto the bezel 102. Reference designators 148 are molded directly into the door 104 to distinguish the push button switches from one another and to show orientation of the battery connection. A flange 150 molded into the back side of the door aligns and supports a gasket 152 that seals the door 104 shut to the bezel 102. A loophole 154, as shown in Figure 5, is molded with the door 104 and provides for sealing the door 104 for tamper resistance. The loophole is designed to be molded so that side action in the mold will not be required, making the cost of the mold less expensive and improves the chances of producing a more reliable part.

Referring now to Figure 6, the top enclosure portion 106 forms a substantial portion of the enclosure 100. Top portion 106 is molded to provide several features which perform specific functions. For example, along the edges of the top portion 106 are continuous triangular energy directors 156 0.015 inches high which when ultrasonically welded to the bottom portion 108 of the enclosure 100 create a hermetic seal. There are four alignment rails 158 along the side walls 160. The rails 158 are used to align the top portion 106 with the bottom portion 108 before being ultrasonically welded. When mated with the bottom portion 108, the rails 158 provide a lead in to self align the portions.

Molded into the top portion 106 is a snap 162 with an opening 164 formed in it to latch the battery hatch door 104 shut. The purpose of the opening 164 is to allow a wire tie to pass through to seal the battery hatch door 104.

Three t-shaped tabs 166 are molded into a floor 168 of the top portion 106. The snaps 166 lock into the bezel tabs 122 when the bezel 102 is assembled to the top portion 106. Two rails 170 molded into the floor 168 of the top portion 106 act as card guides for an option board (not shown) which may be plugged into the back of the register electronics board (not shown).

The top portion 106 also includes a combination of stops 172 including a lead-in 174 to assist placing and holding a transformer (not shown) in proper position. The lead-in 174 has a snap 176 that holds the transformer into place until the rear panel 110 is put into place.

Two tabs 178 hold two u-shaped spring clips (not shown) that slide down over the tabs 178. Forces in the spring clips and the frictional force created between the clips and the tabs 178 hold the clips onto the tabs 178. The spring clips are threaded for a fastener.

A steel spring (not shown in Fig. 6) is used to hold a battery down against the floor 168 when installed. The battery spring is ultrasonically welded to the top portion 106 by deforming three tabs 180. When the three tabs 180 are deformed, they produce a mushroom shaped rivet head to restrain the battery spring.

In order to seal the top portion 106 with the front bezel 102 and rear panel 110, a 0.033 inch wide rim 182 protrudes from the top portion 106, the front bezel 102, the rear panel 110, and the bottom portion 104. The rim 182 in the rear of the top portion 106 protrudes out 0.031 inches from the back of the top portion 106 and squeezes a rear gasket (not shown) to assure sealing to the rear panel 110. The rim 182 also serves for alignment.

Referring now to Figure 7, the bottom enclosure portion 108 includes protrusions 184 out of the front and back to complete the continuous rim around the front and rear peripheries of the enclosure 100 when the top portion 106 and the bottom portion 108 are ultrasonically welded together. The bottom portion 108 contains two rear panel mounting tabs 186 as well as three bezel snap tabs 188, and card guide rails 190. The bottom enclosure portion 108 also includes a stop 192 to contain the transformer. A set of alignment tabs 194 are molded into side walls 196 of the bottom portion 108. In order to direct the ultrasonic energy, a set of lands 198 0.100 inches wide protrude down below the bottom of the bottom enclosure. The wall thickness at the corners is reduced from 0.100 inches to 0.07 inches to minimize sink marks from forming in the side walls of the enclosure, during mold cooling.

Three ribs 200 molded into a floor 202 of the bottom portion 108 hold a battery in position. A backstop 204, also molded into the floor 202, prevent the 1/2 AA or full size AA battery from being pushed too far back into the enclosure 100. When the battery is placed into the holder, it slides up onto the three ribs 200 which support it from moving left or right, while the battery spring clip, staked into the top portion 106, force it down into position, to prevent it from popping out of position.

As a door hinge backup, two tabs 206 protrude down 0.12 inches below the floor 202. These tabs 206 form a backstop when the bezel 102 and the door 104 are assembled.

An air vent 208 is molded into the floor 202 to allow moisture built up from condensation to escape. The vent 208 may be covered with fiberglass screen (not shown) and a spring (not shown) to hold the screen in place to prevent entrance of bugs. To help align the back of the bottom portion 108 to the rear panel 110 during assembly, two tabs 210 are molded into the floor 202.

Referring to Figure 8, the rear panel 110 has a nominal wall thickness of 0.156 inches to provide extra strength for mounting a register circuit board to terminal blocks by flanges 212 and may be shaped to match a specific terminal block pattern.

The panel 110 is removable so as to provide access the transformer for replacement or repair, to access the snaps 122 that hold the front bezel 102 and electronics board assembly into the enclosure 100, and to plug in an optional output board (not shown). Once the enclosure 100 is assembled, the only access to any of the internal components, with the exception of the battery and push-button switches, is by removal of the rear panel 110. Once installed on a terminal block, the rear panel 110 can only be removed if the enclosure 100 is completely removed from the terminal block because mounting screws (not shown) that hold the rear panel 110 to the enclosure are located on the back side. This facilitates making the enclosure tamper resistant. Through four openings 214 (only two are visible in Figure 8), four screws (not shown) fasten to four spring clips (not shown) that are held onto the enclosure rear panel mounting tabs.

Two openings 216 are formed into the rear panel 110 to allow cables to exit for power and optics pickup. A third knockout 218 is added to allow a cable to exit for optional output hookup. The knockout opening 218 has a sharp v-shaped diameter to cause the part to fracture at the minimum material thickness, thus producing a clean diameter when it is punched out. These openings 216 and 218 preferably are filled by strain reliefs and rubber gaskets (not shown) which actually surround a sleeved cable (not shown). The friction between the sleeving and the inside diameter of the strain relief provide a seal to prevent penetration of water. The gasket forms a seal between the strain relief and back panel.

Four bosses 220 (only two are visible in Figure 8) protrude inward in the rear panel 0.75 inches to hold the transformer up against the transformer stops in the top portion 106 and bottom portion 108. The bosses 220 are reinforced by flanges 222 that help the flow of the liquid resin during the molding process. The ends of the bosses 220 are 0.31 inches diameter to allow knockout pins (not shown) to push the finished molded part out of a cavity molding (not shown) once it has been molded.

Two loopholes 224 are molded into the rear panel 110 along the sides so that a wire tie seal (not shown) can be looped through the holes and through holes in the register mounting screws (not shown) to prevent tampering.

Referring now to Figure 9, the molded components 102 - 110 together form a completely thermoplastic environmentally sealed enclosure 100. The top and bottom enclosure portions 106 and 108 are ultrasonically welded together to form a tube shaped housing.

A register circuit board 228 is snapped into the front bezel 102 as hereinbefore described, and then the bezel 102 is snapped into the front of the ultrasonically welded portions 106 and 108. When mated with the front bezel 102, a continuous gasket (not shown) is applied to the mating surfaces of the bezel 102 to seal the interface between the mating parts from penetration of water. When the door 104 is closed, a continuous gasket on the inside of the door 104 seals the interface between the bezel 102 and the door 104 from water penetration.

An optics cable (not shown) is assembled into the rear panel 110 by snapping a strain relief member 226 into one of the openings 216 in the rear panel 110. A connector on one end of the optics cable plugs into the back of the register board 228. A secondary connection plug on the transformer 230 is also plugged into the back of the electronics register board 228. A strain relief 226 with this cable assembly snaps into an opening 216 from the back side of the rear panel 110.

If an optional output board 232 is required, it is slid into the card guides 170 and 190 formed in the top portion 106 and the bottom portion 108 and is plugged into the electronics register board 228. The leads are brought out in a similar fashion to the transformer leads and then a strain relief member (not shown) is snapped into the knockout opening 218 in the rear panel 110.

With the rear panel 110 hanging down and the three cables plugged into their appropriate positions, the transformer 230 is placed into the enclosure 100 against the stops 192. The rear panel 110 is then assembled to the back of and fastened with four screws. As with the front bezel 102, a continuous gasket (not shown) is applied to mating surfaces of the panel 110 to seal the interface between the mating parts from penetration of water. The final step of assembly is to plug in a battery (not shown) to the battery holder and snap the door 104 shut.

Figure 10 is a side view of a spring clip 250 used, for example, to mount the rear panel member 110 to other portions of the enclosure. Particularly, the tab 210 of the bottom portion 108 and the back wall 252 of the rear panel member 110, in combination with a screw 254, are used to support and maintain the rear panel member 110 in removable engagement with the other enclosure portions. The screw 254 is threadedly engaged with the spring clip 250 by arms 256 and 258. As hereinbefore described, four such screws are utilized to maintain the rear panel 110 in engagement.

Figure 11 is a side view of a battery clip 260. As hereinbefore described, the battery clip 260 is welded to the top portion 106 at a top section 262 of the clip 260. A bottom section 264 of the clip 260, in operation, is in contact with a battery and is used to maintain the battery in firm contact with ribs 200 (Fig. 9). The spring 260, for example, is made from steel and is biased so that when in position (See Fig. 9), the spring forces act so as to maintain a battery in place.

While the present invention has been described with respect to specific embodiments, many modifications, variations, substitutions, and equivalents will be apparent to those skilled in the art. For example, although certain components have been described with respect to specific dimensions, the present invention certainly is not limited by those dimensions. Other dimensions are possible. Accordingly, the invention is to be considered as limited only by the spirit and scope of the appended claims.

## Claims

1. An enclosure, comprising:
means for housing a meter register;
means for enabling an observer to view displays on a display of the meter register; and
means for providing that said housing is environmentally sealed.

2. An enclosure in accordance with Claim 1 further comprising means for facilitating connecting, removing, and replacing a battery to the meter register.

3. An enclosure in accordance with Claim 2 wherein said means for facilitating connecting, removing, and replacing a battery to the meter register comprises a door having an opened and a closed position.

4. An enclosure in accordance with Claim 1 further comprising an optical port.

5. An enclosure in accordance with Claim 1 further comprising means for mounting said housing to a terminal meter block.

6. An enclosure in accordance with Claim 1 wherein said enclosure comprises:
a front flange member;
a top portion member;
a bottom portion member; and
a rear panel member.

7. An enclosure in accordance with Claim 6 wherein said top portion, said bottom portion and said rear panel members are substantially constructed from Lexan polycarbonate.

8. An enclosure in accordance with Claim 6 wherein said front flange member comprises a window member and an optical port.

9. An enclosure in accordance with Claim 6 wherein said bottom member comprises transformer stop means and an air vent.

10. An enclosure in accordance with Claim 6 wherein said top member comprises transformer stop means and has a section of a battery holder attached thereto.
